# EUROPEAN PATENT APPLICATION

(11) **EP 2 624 309 A1**
(43) Date of publication of application: **07.08.2013**
(21) Application number: 11828716.8
(22) Date of filing: 05.09.2011
(51) Int. Cl.: H01L 31/042

(54) **OUTER FRAME OF SOLAR CELL MODULE AND SOLAR CELL MODULE**

(30) Priority: 27.09.2010 JP 2010214701
(71) Applicant: Sanyo Electric Co., Ltd., Osaka 570-8677 (JP)
(72) Inventor: YAGI, Yasuhiro, Moriguchi-shi Osaka 570-8677 (JP)
(74) Representative: Metzler, Volker
(86) International application number: PCT/JP2011/070153
(87) International publication number: WO 2012/043155

(57) **Abstract**

A solar cell module (10) comprises: a solar panel (20) in which a plurality of solar cells (206) converting sunlight into electrical power on both front and back surfaces are sandwiched between front and back light-transmissive members via a filler; an outer frame (30) into which the solar panel (20) is fitted; and a DC-AC converting circuit (50) that converts the power generated by the solar cells (206) and is attached to the outer frame.

## Description

### CROSS-REFERENCE TO RELATED APPLICATION

The present application is a continuation application of International Application No. PCT/JP2011/070153, filed September 5, 2011, the entire contents of which are incorporated herein by reference and priority to which is hereby claimed. The PCT/JP2011/070153 application claimed the benefit of the date of the earlier filed Japanese Patent Application No. 2010-214701 filed September 27, 2010, the entire content of which is incorporated herein by reference, and priority to which is hereby claimed.

### [TECHNICAL FIELD]

The present invention relates to an outer frame of a solar cell module and a solar cell module.

### [BACKGROUND ART]

Recently, development of solar cell modules has become popular as environmentally friendly clean energy. Electric power generated by a solar cell is converted by an electric power conversion circuit in some cases. For example, because the electric power generated by a solar cell is DC power, a DC-AC conversion is performed when the DC power is supplied to a load which operates with AC power.

As a technique related to the present invention, Patent Document 1, for example, discloses a solar cell device which includes a solar cell module with two or more solar cells; and an inverter device which converts DC power output from the solar cells to AC power and outputs the AC power. The inverter device is installed on a surface on the opposite side to a light receiving surface side of the solar cell module, with a space therebetween.

### [PRIOR ART DOCUMENT]

### [Patent Documents]

Patent Document 1: JP 9-271179A

### [DISCLOSURE OF THE INVENTION]

### [Objects to be Achieved by the Invention]

It should be noted that for general single-sided power generation type solar cells, it is possible to position an electric power conversion circuit on a back surface of a solar cell module, and this back surface does not contribute to power generation. However, for double-sided power generation type solar cells, if an electric power conversion circuit is positioned on a back surface of a solar cell module, a shaded area may be formed on the solar cell on the back surface side, lowering efficiency of generating power in the shaded portion. Therefore, an electric power conversion circuit may be positioned so as to be away from the double-sided power generation type solar cells (for example, on a pole supporting the solar cell module).

However, if an electric power conversion circuit is positioned at a location away from the double-sided power generation type solar cell, an electric power loss becomes larger because the length of the electric wire connected from the solar cell to the electric power conversion circuit becomes longer.

An object of the present invention is to provide a solar cell module which enables a reduction in electric power loss due to a long electric power wire for retrieving electric power generated by a solar cell.

### [Means for Achieving the Objects]

An outer frame of solar cell module according to the present invention comprises an outer frame into which a solar panel is internally fitted, the solar panel having a plurality of solar cells for converting sunlight into electric power sandwiched between front and back light-transmissive members via a filler; and an attachment portion to which an electric power conversion circuit which converts electric power generated by the solar cell is attached, wherein the outer frame and the attachment portion are positioned to at least partially overlap each other when the outer frame is viewed from a front of the sunlight incident side.

A solar cell module according to the present invention comprises the above described outer frame of a solar cell module and the electric power conversion circuit attached to the attachment portion, wherein the electric power conversion circuit is attached to be overlapped with the outer frame when the electric power conversion circuit is viewed from the front of the sunlight incident side.

### [Effects of the Invention]

According to the above configuration, because it is possible to attach an electric power conversion circuit to an outer frame in which a solar panel sandwiching two or more solar cells is internally fitted, the length of power wire used to retrieve electric power generated by solar cells can be made shorter than in a case where the electric power conversion circuit is positioned away from a solar cell module. In this way, it is possible to reduce electric power loss due to the electric power wire used to retrieve electric power generated by solar cells.

### [BRIEF DESCRIPTION OF THE DRAWINGS]

FIG. 1 is a solar cell module in an embodiment according to the present invention.
FIG. 2 is a cross-sectional view taken along the line A-A in FIG. 1.
FIG. 3 is a solar cell array in an embodiment according to the present invention.
FIG. 4 is a view of a cross-sectional view taken along the line A-A in FIG. 3 seen from the direction indicated by the arrow B.
FIG. 5 is a view when a DC-AC conversion circuit is attached to an outer frame in an embodiment according to the present invention.
FIG. 6 is a view when a DC-AC conversion circuit is attached to an outer frame in an embodiment according to the present invention.
FIG. 7 is a first variation example of a solar cell array in an embodiment according to the present invention.
FIG. 8 is a second variation example of a solar cell array in an embodiment according to the present invention.
FIG. 9 is a view with a variation example of an attachment portion being attached in an embodiment according to the present invention.
FIG. 10 is a view with a variation example of an attachment portion being attached.
FIG. 11 is a view with a variation example of an attachment portion being attached.
FIG. 12 is a view with a variation example of an attachment portion being attached.

### [BEST MODE FOR CARRYING OUT THE INVENTION]

By referring to the drawings, embodiments according to the present invention will be described in detail below. Although an electric power conversion circuit is assumed to be a DC-AC conversion circuit in the description below, the electric power conversion circuitmaybe of another type, such as a DC-DC conversion circuit. Further, although a terminal box and a DC-AC conversion circuit are described as separate elements in the description below, the functions of the terminal box may be integrated into the DC-AC conversion circuit.

Furthermore, in the description below, for similar elements, the same reference numerals are assigned and redundant descriptions are omitted. In the text, a reference numeral used in a previous similar description will be used again, if applicable.

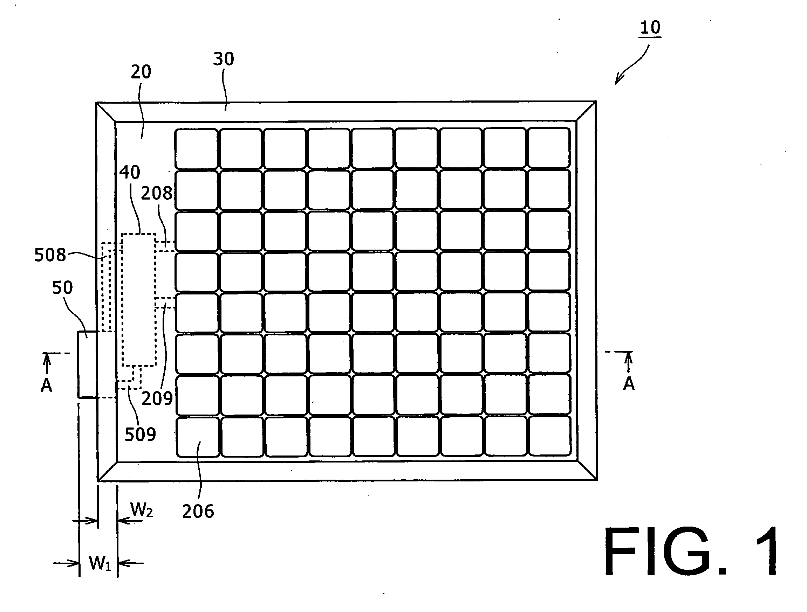

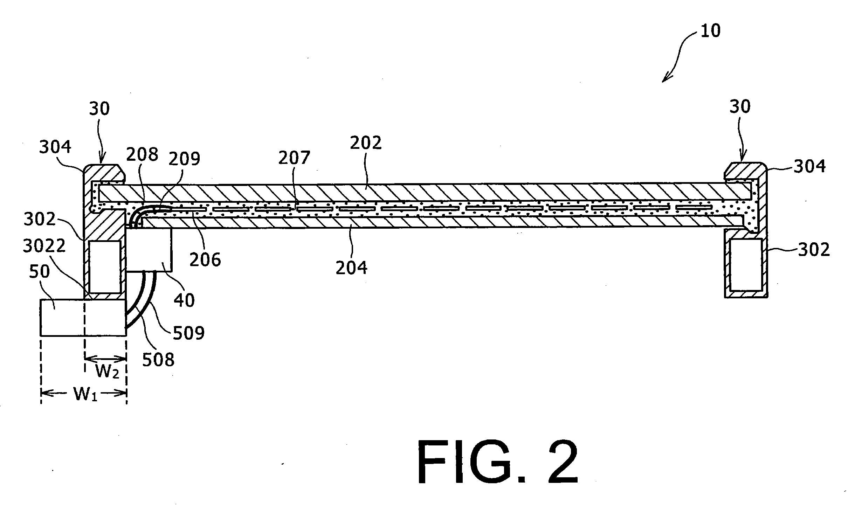

FIG. 1 shows a solar cell module 10. FIG. 2 is a cross-sectional view taken along the line A-A in FIG. 1. The solar cell module 10 is configured to include a solar panel 20, an outer frame 30, a terminal box 40, and a DC-AC conversion circuit 50.

The solar panel 20 is configured to include a front light-transmissive substrate 202, a back light-transmissive substrate 204, two or more solar cells 206, and transparent encapsulation resin 207. Each of the front light-transmissive substrate 202 and the back light-transmissive substrate 204 is a plate member formed by white plate glass or the like.

The solar cell 206 is a photovoltaic element which converts light to DC power on both sides, specifically a front side on which incident sunlight is received and a backside on which reflected sunlight or the like is received. Further, the two or more solar cells 206 are aligned in lines with sufficient space therebetween. The solar cells 206 are sandwiched between the front light-transmissive substrate 202 provided on the front side and the back light-transmissive substrate 204 provided on the backside, with the transparent encapsulation resin 207 filled in a space therebetween. The transparent encapsulation resin 207 can be formed by using, for example, ethylene-vinyl acetate (EVA).

It should be noted here that a positive side connection lead 208 which is an anode conductor and a negative side connection lead 209 which is a cathode conductor are arranged in the solar panel 20 in order to output, outside the solar panel 20, DC power generated by the solar cell 206. Inside the terminal box 40, the positive side connection lead 208 and the negative side connection lead 209 are respectively connected to a positive side power wire 508 and a negative side power wire 509 of the DC-AC conversion circuit 50.

The outer frame 30 is a frame in which the solar panel 20 is internally fitted via a seal material (not shown). The outer frame 30 is manufactured by an extrusion process of aluminum or the like. The outer frame 30 includes, in the upper part of a body portion 302, a cross-sectionally U-shaped engagement portion 304 into which an edge portion of the solar panel 20 is inserted. It is preferable that the body portion 302 is structured to be hollow to reduce weight, but relatively thick and strong.

The terminal box 40 is an enclosure used to internally connect between the positive side connection lead 208 and the positive side power wire 508, and between the negative side connection lead 209 and the negative side power wire 509. Further, the terminal box 40 is fixed by adhesion of the like to the back light-transmissive substrate 204 which is on the opposite side to the front side of the solar cell module 10 in order to avoid deterioration or the like due to receiving direct sunlight.

The DC-AC conversion circuit 50 has a function to convert, to AC power, DC power which is input by the positive side power wire 508 and the negative side power wire 509. More specifically, the DC-AC conversion circuit 50 converts DC power generated by the solar cell 206 to AC power to be supplied to an external load (not shown) which operates on AC power.

Further, the DC-AC conversion circuit 50 is attached to a bottom surface 3022 of a body portion 302 of the outer frame 30 by a below-described attachment portion. Furthermore, the DC-AC conversion circuit 50 is preferably placed in a position near the location where the terminal box 40 is disposed. The position near the location where the terminal box 40 is disposed is, among four regions corresponding to four edges of the outer frame 30, the position included in the region nearest to the location where the terminal box 40 is disposed. More preferably, the position is where the distance between the positive side power wire 508 and the negative side power wire 509 becomes shortest.,

As shown in FIGs. 1 and 2, the width W₁ of the DC-AC conversion circuit 50 may be longer than the width W₂ of the outer frame 30. In such a case, when the solar cell module 10 is viewed from the front of sunlight incident side, the DC-AC conversion circuit 50 is fixed to be overlapped with the outer frame 30 in such a manner that the DC-AC conversion circuit 50 does not protrude towards the inner side of the outer frame 30 but does protrude towards the outer side of the outer frame 30. The positive side power wire 508 and the negative side power wire 509 respectively extend from the DC-AC conversion circuit 50 toward the terminal box 40, where they are respectively connected to the positive side connection lead 208 and the negative side connection lead 209. On the other hand, if the width W₁ of the DC-AC conversion circuit 50 is shorter than the width W₂ of the outer frame 30, the DC-AC conversion circuit 50 can be fixed while being overlapped with the outer frame 30 in such a manner that the DC-AC conversion circuit 50 does not protrude towards either the inner side or outer side of the outer frame 30.

The operations of the solar cell module 10 are described below.
In order to use DC power generated by the solar cell 206 in an external load which operates in AC power, the DC power needs to be converted to AC power by the DC-AC conversion circuit 50. It should be noted here that because the DC-AC conversion circuit 50 is attached to the outer frame 30 into which the solar panel 20 is internally fitted, the lengths of the positive side power wire 508 and the negative side power wire 509 can be made shorter than in a case where the DC-AC conversion circuit 50 is positioned away from the solar cell module 10. Furthermore, in the solar cell module 10, because the DC-AC conversion circuit 50 is attached to the position near the location where the terminal box 40 is disposed, it is possible to make the lengths of the positive side power wire 508 and the negative side power wire 509 even shorter. Therefore, according to the solar cell module 10, it becomes possible to reduce electric power loss due to a long wiring length of the positive side power wire 508 and the negative side power wire 509.

Further, in the solar cell module 10, because the DC-AC conversion circuit 50 is fixed in such a manner that the DC-AC conversion circuit 50 does not protrude towards the inner side of the outer frame 30 but does protrude towards the outer side of the outer frame 30, it is possible to prevent the DC-AC conversion circuit 50 from blocking reflection light towards the solar cell 206. Therefore, according to the solar cell module 10, it is possible to reduce electric power loss and further prevent decline in conversion efficiency of the solar cell 206.

It should be noted that, in the description above, it is assumed that the DC-AC conversion circuit 50 does not protrude towards the inner side of the outer frame 30, but the DC-AC conversion circuit 50 may protrude towards the inner side of the outer frame 30 to some extent as long as the DC-AC conversion circuit 50 does not block the reflection light of the solar cell 206. This can be a case, for example, where the outermost periphery of the solar panel 20 and the solar cell 206 are spaced apart. In FIG. 1, the outermost periphery of the solar panel 20 on which the DC-AC conversion circuit 50 is disposed and the solar cell 206 are spaced apart. Therefore, even if the DC-AC conversion circuit 50 protrudes towards the inner side of the outer frame 30, it can be assumed that the DC-AC conversion circuit 50 does not block reflection light to the solar cell 206.

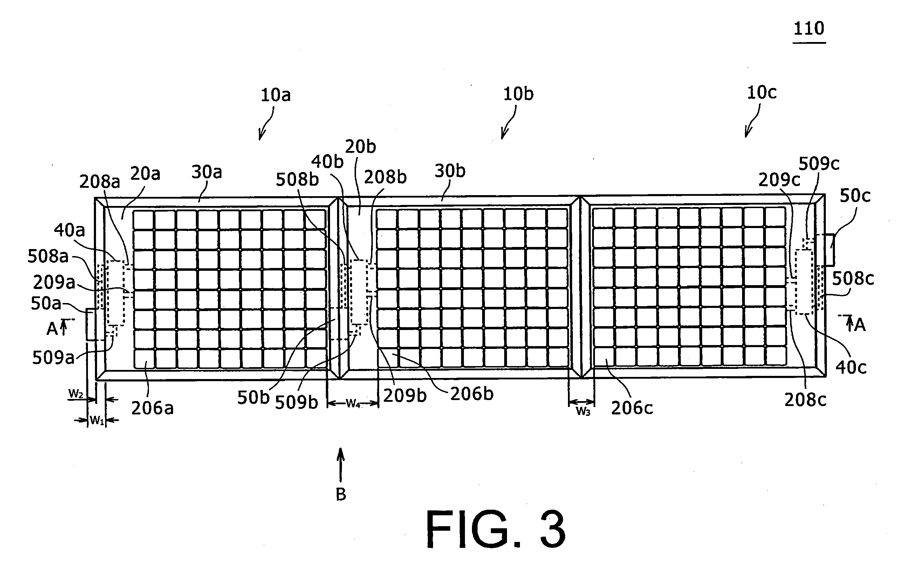

FIG. 3 shows a solar cell array 110. Described below is the solar cell array 110 in which solar cell modules 10a, 10b, 10c are aligned. The solar cell array 110 is configured to include the solar cell module 10a, solar cell module 10b, and solar cell module 10c. Because each of the solar cell modules 10a, 10b, 10c has the same configuration as the solar cell module 10, detailed description of each module is omitted. It should be noted here that as shown in FIG. 3, the solar cell module 10c is rotated 180 degrees to the right compared with the arrangement of the solar cell modules 10a, 10b. It should be further noted that although the solar cell array 110 is described to have the solar cell modules 10a, 10b, 10c aligned in three columns in one line as shown in FIG. 3, the solar cell array 110 may of course be configured to have more or less columns and lines by increasing and decreasing the number of the solar cell modules.

As shown in FIG. 3, the width W₁ of the DC-AC conversion circuit 50a is about twice the width W₂ of the outer frame 30a. Similarly, because the solar cell modules 10a, 10b, 10c have the same configuration, the width W₁ of the DC-AC conversion circuit 50b is twice the width W₂ of the outer frame 30b, and the width W₁ of the DC-AC conversion circuit 50c is twice the width W₂ of the outer frame 30c.

In the solar cell module 10a, the DC-AC conversion circuit 50a is attached to an outer frame 30a on the opposite side to the outer frame 30b of the solar cell module 10b next to the solar cell module 10a. Further, when the solar cell module 10a is viewed from the front of the sunlight incident side, the DC-AC conversion circuit 50a is attached to be overlapped with the outer frame 30a in such a manner that the DC-AC conversion circuit 50a does not protrude towards the inner side of the outer frame 30a but does protrude towards the outer side of the outer frame 30a.

In the solar cell module 10b, the DC-AC conversion circuit 50b is attached to extend to both of the outer frame 30b and the outer frame 30a of the solar cell module 10a next to the solar cell module 10b. Further, when the solar cell module 10b is viewed from the front of sunlight incident side, the DC-AC conversion circuit 50b is fixed to be overlapped with the outer frames 30a, 30b in such a manner that the DC-AC conversion circuit 50b does not protrude toward the inner side of the outer frame 30a and inner side of the outer frame 30b.

In the solar cell module 10c, the DC-AC conversion circuit 50c is attached to an outer frame 30c on the opposite side to the outer frame 30b of the solar cell module 10b next to the solar cell module 10c. Further, when the solar cell module 10c is viewed from the front of sunlight incident side, the DC-AC conversion circuit 50c is attached to be overlapped with the outer frame 30c in such a manner that the DC-AC conversion circuit 50c does not protrude towards the inner side of the outer frame 30c but does protrude towards the outer side of the outer frame 30c.

The operations of the solar cell array 110 are described below.
Because the DC-AC conversion circuits 50a, 50b, 50c of the solar cell modules 10a, 10b, 10c are respectively attached to outer frames 30a, 30b, 30c, the lengths of the positive side power wires 508a, 508b, 508c and the negative side power wires 509a, 509b, 509c can be made shorter than in a case where the DC-AC conversion circuits 50a, 50b, 50c are attached away from the solar cell array 110. Further, in the solar cell array 110, because the DC-AC conversion circuits 50a, 50b, 50c are attached at a position near to the location where the terminal boxes 40a, 40b, 40c are disposed, the lengths of the positive side power wires 508a, 508b, 508c and the negative side power wires 509a, 509b, 509c can be made even shorter. In this way, by using the solar cell array 110, it becomes possible to reduce electric power loss due to a long wiring length of the positive side power wires 508a, 508b, 508c and the negative side power wires 509a, 509b, 509c of the solar cell modules 10a, 10b, 10c.

Further, in the solar cell module 10a, because the DC-AC conversion circuit 50a is attached in such a manner that the DC-AC conversion circuit 50a is overlapped with the outer frame 30a when the solar panel 20 is viewed from the front of the sunlight incident side, and further that the DC-AC conversion circuit 50a is fixed without protruding towards the inner side of the outer frame 30a, it is possible to prevent the DC-AC conversion circuit 50a from blocking reflection light towards the back surface of the solar cell 206a. In this way, by using the solar cell module 10a, it becomes possible to reduce electric power loss and further prevent decline in conversion efficiency of the solar cell 206a. As for the DC-AC conversion circuit 50c, the same advantages as the DC-AC conversion circuit 50a can be achieved.

Further, in the solar cell module 10b, because the DC-AC conversion circuit 50b is attached in such a manner that the DC-AC conversion circuit 50b is overlapped with the outer frames 30a, 30b when the solar cell module 10b is viewed from the front of sunlight incident side, and further that the DC-AC conversion circuit 50b is fixed without protruding towards the inner side of the outer frame 30a and the inner side of the outer frame 30b, it is possible to prevent the DC-AC conversion circuit 50b from blocking reflection light towards the back surfaces of the solar cells 206a, 206b. In this way, by using the solar cell module 10b, it becomes possible to reduce electric power loss and further prevent decline in conversion efficiency of the solar cells 206a, 206b.

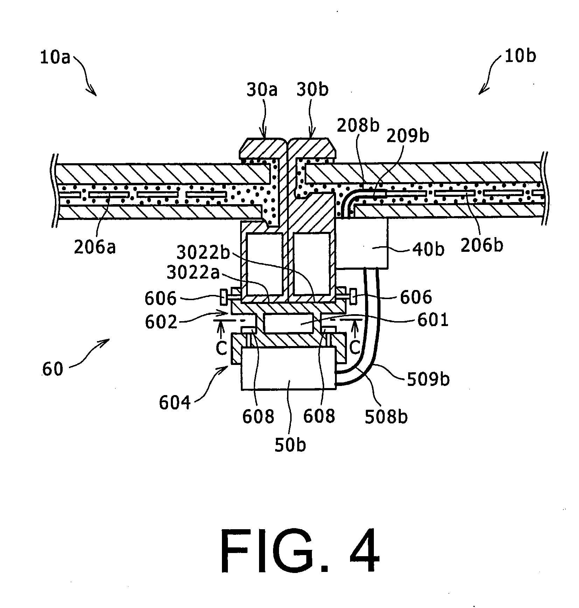

FIG. 4 shows a view of the cross-sectional view taken along the line A-A in FIG. 3 seen from the direction indicated by the arrow B. By referring to FIG. 4, an exemplary embodiment in which the DC-AC conversion circuit 50b is attached to the outer frames 30a, 30b with an attachment portion 60 will be described below.

The attachment portion 60 is configured to include an outer frame holder 602 and a circuit holder 604.

The outer frame holder 602 includes an outer frame holding surface having a width which is equal to the addition of the width W₂ of the outer frame 30a and the width W₂ of the outer frame 30b. The outer frame holder 602 has a shape sufficient to sandwich the neighboring outer frames 30a, 30b. It should be noted here that the attachment portion 60 is attached in such a manner that at least a portion of the attachment portion 60 is overlapped with the outer frames 30a, 30b when the solar cell module 10 is viewed from the front of the sunlight incident side. The outer frame holding surface of the outer frame holder 602 is positioned to face the bottom surface 3022a of the outer frame 30a and the bottom surface 3022b of the outer frame 30b. By tightening a fastening member 606, the outer frames 30a, 30b are fixed so as not to be displaced with respect to each other such that the attachment portion 60 is attached to the outer frames 30a, 30b.

The circuit holder 604 is configured to include a circuit holding surface having a width which is about equal to the width W₁ of the DC-AC conversion circuit 50b. The circuit holder 604 has a shape sufficient to sandwich the top portion of the DC-AC conversion circuit 50b. The DC-AC conversion circuit 50b is positioned on the circuit holding surface side of the circuit holder 604. The DC-AC conversion circuit 50b is attached to the attachment portion 60 by tightening a fastening member 608. It should be noted that the circuit holder 604 may be designed to have a shape almost symmetrical to the outer frame holder 602 with the C-C line in FIG. 4 as the central axis.

By using the attachment portion 60, the DC-AC conversion circuit 50b can be securely fixed on the outer frames 30a, 30b. Further, the attachment portion 60 can fix the DC-AC conversion circuit 50b at a position where the DC-AC conversion circuit 50b does not protrude outside the widths of the outer frames 30a, 30b.

Further, as shown in FIG. 4, the attachment portion 60 described above includes a hollow portion 601. Generally, it is preferable that direct sunlight is irradiated onto the solar cell modules 10a, 10b, 10c. However, this raises the surface temperature of the solar cell modules 10a, 10b, 10c. Thus, by placing the DC-AC conversion circuits 50a, 50b, 50c away from the solar cell modules 10a, 10b, 10c, it becomes possible to suppress heating of the DC-AC conversion circuits 50a, 50b, 50c. However, the temperature of the outer frames 30a, 30b, 30c is increased due to heat transferred from the solar cell modules 10a, 10b, 10c. Therefore, by providing the hollow portion 601 with the attachment portion 60, it becomes possible to preferably reduce influence of the temperature increase of the outer frames 30a to 30c on the DC-AC conversion circuits 50a to 50c.

When the DC-AC conversion circuit 50b is positioned to extend to both of neighboring outer frames 30a, 30b as shown in FIG.3, the width W₁ of the DC-AC conversion circuit 50b is preferably shorter than a distance W₄ which is the shortest between one of the two or more solar cells 206a of the solar cell module 10a and one of the two or more solar cells 206b of the solar cell module 10b which is next to the solar cell module 10a.

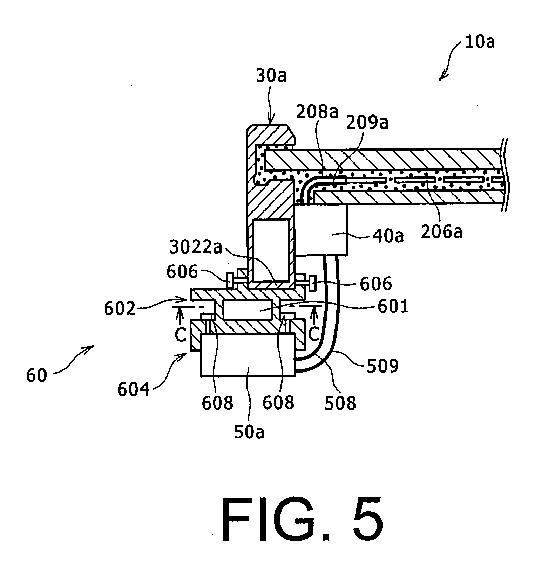

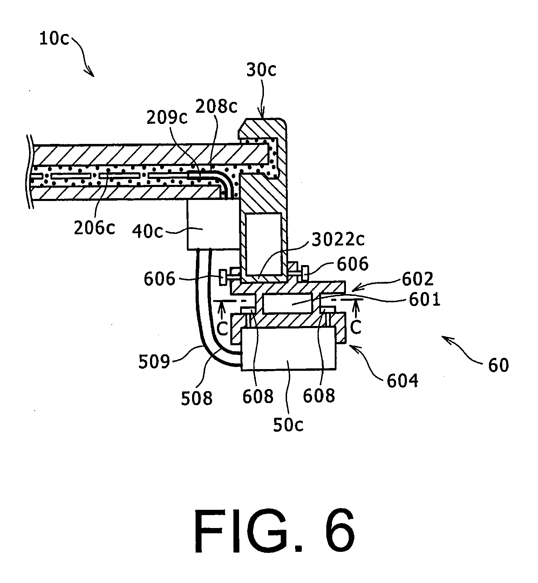

It should be noted that the DC-AC conversion circuits 50a, 50c may be attached to the outer frames 30a, 30c by using a similar attachment portion 60. FIG. 5 shows a view when the DC-AC conversion circuit 50a is attached to the outer frame 30a. FIG. 6 shows a view when the DC-AC conversion circuit 50c is attached to the outer frame 30c. As shown in FIGs. 5 and 6, in the case of the DC-AC conversion circuits 50a, 50c, because these circuits are not positioned to extend to both of the neighboring outer frames like the DC-AC conversion circuit 50b, the attachment portion 60 can be applied by adjusting the width of the outer frame holding surface of the outer frame holder 602 to be equal to a width of each of the outer frames 30a, 30c. As for the attachment portion 60 for attaching the DC-AC conversion circuits 50a, 50c, the width of the outer frame holding surface may be longer than the width of outer frames 30a, 30c.

For example, the DC-AC conversion circuit 50c in FIG. 3 may be alternatively positioned to extend to the outer frame 30b and the neighboring outer frame 30c. In this case, the width W₁ of the DC-AC conversion circuit 50c is preferably shorter than a distance W₃ which is the shortest between one of the two or more solar cells 206b located on the solar cell module 10c side and one of the two or more solar cells 206c located on the solar cell module 10b side. In other words, it is preferable that the width W₁ of the DC-AC conversion circuit 50c is shorter than twice the total length of width between an internal edge portion of the outer frame 30b to which the DC-AC conversion circuit 50b is attached and, among the two or more solar cells 206b, the outer-most solar cell 206b, plus the width of the outer frame 30b.

Although the DC-AC conversion circuits 50a, 50b, 50c are described in the above as not protruding towards the inner side of the outer frames 30a, 30b, 30c, the DC-AC conversion circuits 50a, 50b, 50c may respectively protrude towards the inner side of the outer frames 30a, 30b, 30c to some extent as long as the DC-AC conversion circuits 50a, 50b, 50c do not block the reflection light of the solar cells 206a, 206b, 206c.

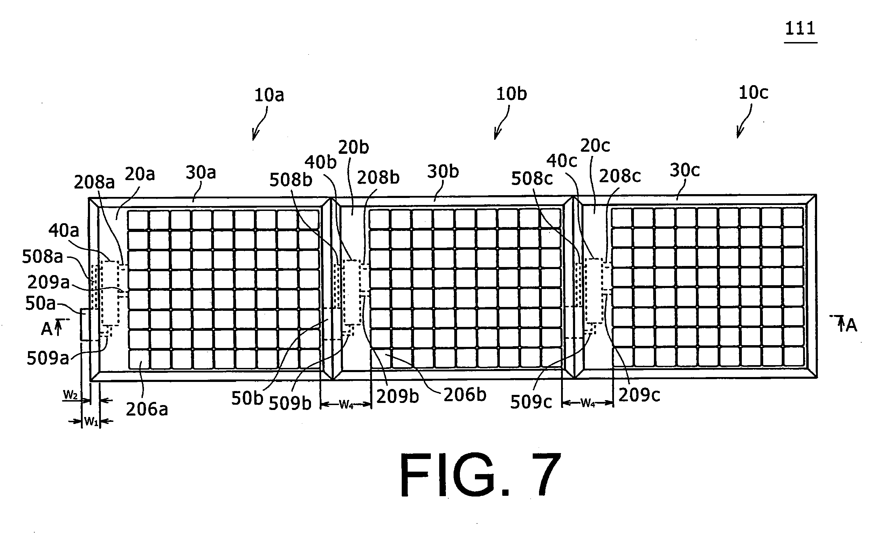

FIG. 7 shows a solar cell array 111 which is a first variation example of the solar cell array 110. The solar cell array 111 differs from the solar cell array 110 only in that the solar cell module 10c is aligned without rotation, that is, in the same arrangement as the solar cell modules 10a, 10b. The DC-AC conversion circuits 50a, 50b, 50c are respectively attached to the outer frames 30a, 30b, 30c. Because the solar cell array 111 is positioned such that the DC-AC conversion circuits 50a, 50b, 50c do not block the reflection light towards the solar cells 206a, 206b, 206c, the solar cell array 111 provides a similar advantage to the solar cell array 110.

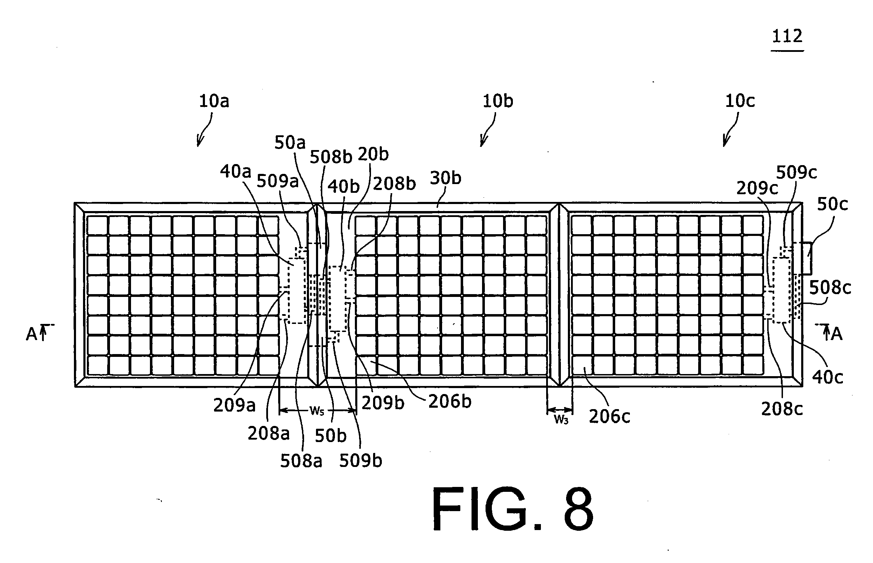

FIG. 8 shows a solar cell array 112 which is a second variation example of the solar cell array 110. The solar cell array 112 differs from the solar cell array 110 in that the solar cell module 10a is rotated 180 degrees to the right compared with the arrangement of the solar cell module 10b. It should be noted here that the DC-AC conversion circuits 50a, 50b are positioned to extend to both of the outer frames 30a, 30b in such a position where the DC-AC conversion circuits 50a, 50b do not overlap each other.

In the solar cell array 112, because the DC-AC conversion circuits 50a, 50b, 50c are respectively attached to the outer frames 30a, 30b, 30c at such a position that the DC-AC conversion circuits 50a, 50b, 50c do not block reflection light towards the solar cells 206a, 206b, 206c, the solar cell array 112 provides a similar advantage to the solar cell array 110.

In this case, the width W₁ of the DC-AC conversion circuits 50a, 50b is preferably shorter than a distance W₅ which is the shortest between one of the two or more solar cells 206a of the solar cell module 10a and one of the two or more solar cells 206b of the solar cell module 10b which is next to the solar cell module 10a. In other words, it is preferable that the width W₁ of the DC-AC conversion circuits 50a, 50b is shorter than twice the total length of the width of the outer frame 30a plus the width between an internal edge portion of the outer frame 30a to which the DC-AC conversion circuit 50a is attached and the outer-most solar cell 206a among the two or more solar cells 206a.

As described above, the DC-AC conversion circuits 50a, 50b, 50c may be attached to various positions of the outer frames 30a, 30b, 30c and have any width as long as the DC-AC conversion circuits 50a, 50b, 50c do not block the reflection light towards the solar cells 206a, 206b, 206c when the DC-AC conversion circuits 50a, 50b, 50c are respectively attached to the outer frames 30a, 30b, 30c.

It should be noted that a similar effect achievable by the conversion of sunlight received on both sides of the solar cell module 10 to DC power can be achieved by using an arrangement in which two solar cell modules, which convert sunlight received only on the front side to DC power, are bonded together. When such solar cell modules are used, attachment portions are still preferably attached to outer frames of the solar cell modules.

Although in the embodiments above the outer frame of the solar cell module and the attachment portion are configured as separate elements, the outer frame and the attachment portion may be integrally formed.

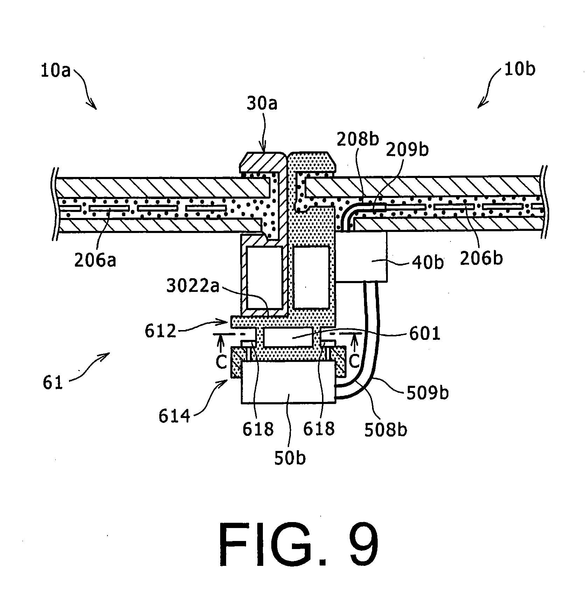

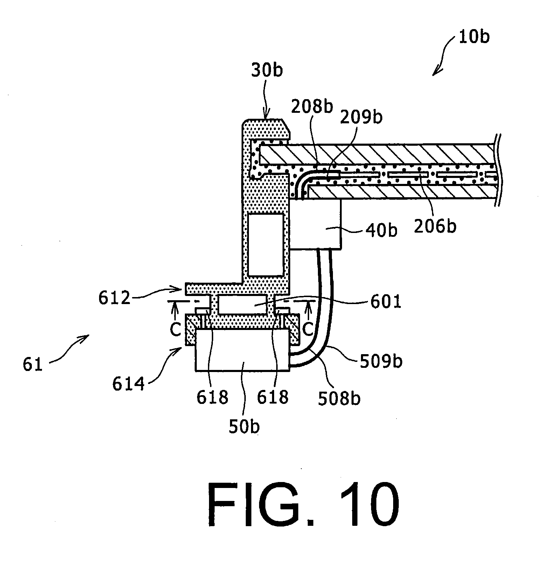

FIG. 9 shows an attachment portion 61 in which the outer frame 30b and the attachment portion 60 shown in FIG. 4 are integrally formed. FIG. 10 shows a view in which the attachment portion 61 is attached with no outer frame 30a in FIG. 9. As shown in FIGS. 9 and 10, by using the attachment portion 61 in which the outer frame 30b and the attachment portion 60 are integrally formed, cost reduction can be achieved because the fastening member 606 can be omitted.

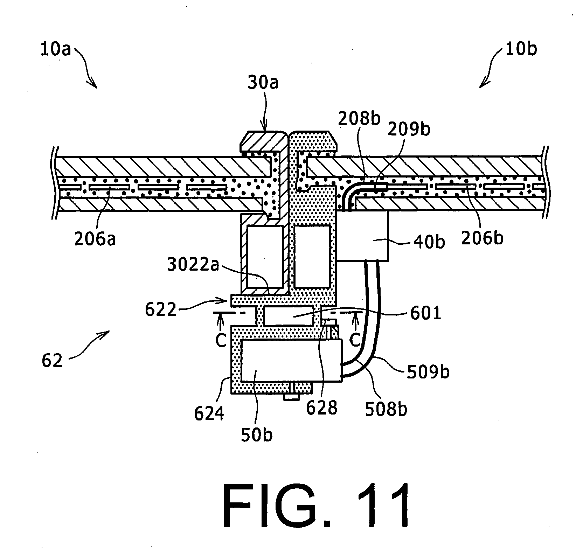

Further, FIG. 11 illustrates an attachment portion 62 which is a variation example of the attachment portion 61. The attachment portion 62 differs from the attachment portion 61 in its circuit holder 624. As shown in FIG. 11, the circuit holder 624 has a substantially U-shaped cross section in which the DC-AC conversion circuit 50b can be internally received. The DC-AC conversion circuit 50b is fixed by tightening a fastening member 628. As shown in FIG. 11, by using the attachment portion 62, it becomes possible to prevent the DC-AC conversion circuit 50b from dropping off from the attachment portion 62 because the attachment portion 62 supports the bottom surface of the DC-AC conversion circuit 50b.

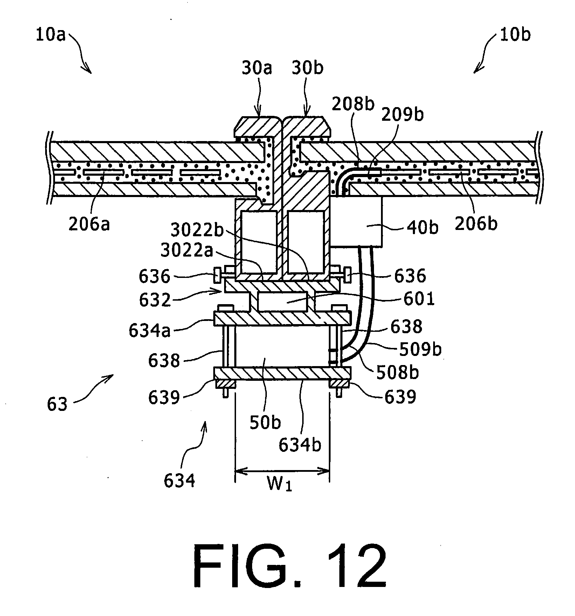

Corresponding to FIG. 4, FIG. 12 is a drawing in which an attachment portion 63 which is another variation example of the attachment portion 60 is attached. The attachment portion 63 is configured to include an outer frame holder 632 and a circuit holder 634. As the attachment portion 63 differs from the attachment portion 60 in its circuit holder 634, this difference is mainly described below.

The circuit holder 634 includes an upper holding portion 634a and a lower holding portion 634b, each having a width wider than the width W₁ of the DC-AC conversion circuit 50b. The upper holding portion 634a and the lower holding portion 634b are positioned so as to sandwich the upper portion and lower portion of the DC-AC conversion circuit 50b. It should be noted that, as shown in FIG. 12, each of the upper holding portion 634a and the lower holding portion 634b protrudes from both sides of the DC-AC conversion circuit 50b. As shown in FIG. 12, the upper holding portion 634a and the lower holding portion 634b are coupled by using a screw 638 which penetrates regions formed by the protruding portions. By tightening a screw stopper 639, the DC-AC conversion circuit 50b is attached to the attachment portion 63. In this way, the DC-AC conversion circuit 50b can be attached to the attachment portion 63 without providing a hole or the like in the DC-AC conversion circuit 50b.

### [REFERENCE NUMERALS]

10, 10a, 10b, 10c solar cell module, 20 solar panel, 30, 30a, 30b, 30c outer frame, 40, 40a, 40b, 40c terminal box, 50, 50a, 50b, 50c DC-AC conversion circuit, 60 attachment portion, 110, 111, 112 solar cell array, 202 front light-transmissive substrate, 204 back light-transmissive substrate, 206, 206a, 206b, 206c solar cell, 207 transparent encapsulation resin, 208 positive side connection lead, 209 negative side connection lead, 302 body portion, 304 engagement portion, 508, 508a, 508b, 508c positive side power wire, 509, 509a, 509b, 509c negative side power wire, 602 outer frame holder, 604 circuit holder, 606 fastening member, 608 fastening member, 3022, 3022a, 3022b bottom surface.

## Claims

1. An outer frame of solar cell module comprising:
an outer frame into which a solar panel is internally fitted, the solar panel having a plurality of solar cells for converting sunlight into electric power sandwiched between front and back light-transmissive members via a filler; and
an attachment portion to which an electric power conversion circuit which converts electric power generated by the solar cell is attached,
wherein the outer frame and the attachment portion are positioned to least partially overlap each other when the outer frame is viewed from a front of a sunlight incident side.

2. A solar cell module comprising the outer frame of solar cell module according to claim 1 and the electric power conversion circuit attached to the attachment portion,
wherein the electric power conversion circuit is attached to be overlapped with the outer frame when the electric power conversion circuit is viewed from the front of a sunlight incident side.

3. The solar cell module according to claim 2,
wherein the electric power conversion circuit has a width which is shorter than twice a total length of a width of the outer frame plus a shortest distance between an internal edge portion of the outer frame to which the electric power conversion circuit is attached and an outer-most solar cell among the plurality of solar cells.

4. The solar cell module according to claim 2 or 3,
wherein the electric power conversion circuit is attached so as to protrude outside the outer frame.

5. The solar cell module according to claim 4,
wherein when a plurality of the solar cell modules are aligned, and the electric power conversion circuit is attached to extend to a neighboring outer frame which is the outer frame of the neighboring solar cell module, the solar cell module comprises an attachment portion which includes:
an outer frame holder which holds the outer frame and the neighboring outer frame in such a manner that the outer frame holder extends to both of the outer frame and the neighboring outer frame; and
a circuit holder which is connected to the outer frame holder and attaches the electric power conversion circuit in such a manner that the circuit holder sandwiches the electric power conversion circuit.

6. The solar cell module according to claim 5,
wherein the outer frame holder comprises a fastening member which fastens the outer frame and the neighboring outer frame.

7. The solar cell module according to claim 4,
wherein when a plurality of the solar cell modules are aligned, and
the electric power conversion circuit is attached to the outer frame on a side with no neighboring outer frame which is the outer frame of the neighboring solar cell module.
